Europäisches Patentamt

European Patent Office

Office européen des brevets

(11) Veröffentlichungsnummer: **0 253 206**
**A2**

(12) **EUROPÄISCHE PATENTANMELDUNG**

(21) Anmeldenummer: 87109467.8

(22) Anmeldetag: 01.07.87

(51) Int. Cl.⁴: **H05K 7/20**

(30) Priorität: **03.07.86 DE 3622386**

(43) Veröffentlichungstag der Anmeldung:
**20.01.88 Patentblatt 88/03**

(84) Benannte Vertragsstaaten:
**AT BE CH DE FR GB IT LI NL**

(71) Anmelder: **Siemens Aktiengesellschaft Berlin und München**
**Wittelsbacherplatz 2**
**D-8000 München 2(DE)**

(72) Erfinder: **Peitz, Elmar, Dipl.-Ing.**
**Pfarrer-Herz-Strasse 2 c**
**D-8900 Augsburg 22(DE)**
Erfinder: **Schmalzl, Dieter**
**Reichenaustrasse 33**
**D-8000 München 60(DE)**
Erfinder: **Materlik, Peter, Dipl.-Ing.**
**Sudetenstrasse 5**
**D-8900 Augsburg 21(DE)**

(54) **Einrichtung zum Flüssigkeitskühlen von Zentraleinheiten.**

(57) Jeder Zentraleinheit sind zur Flüssigkeitskühlung zwei in getrennten Schränken befindliche Kühlaggregate zugeordnet, die über eine abtrennbare Kühlmittelleitung miteinander verbunden sind, wobei vor und nach jeder Trennstelle ein Kühlmittelabsperrhahn vorgesehen ist.

## Einrichtung zum Flüssigkeitskühlen von Zentraleinheiten

Die Erfindung betrifft eine Einrichtung zum Flüssigkeitskühlen von Zentraleinheiten der Datentechnik.

Für die Kühlung hochintegrierter elektronischer Baugruppen in Datenverarbeitungsanlagen werden zur Abführung der Verlustleistungswärme Kühlkreisläufe eingesetzt, wobei als Kühlmittel z.B. Wasser verwendet werden kann. Um eine hohe Zuverlässigkeit kompletter Systeme von Zentraleinheit und Kühlaggregat zu erreichen ist es erforderlich, das Kühlaggregat redundant auszuführen.

Aufgabe der vorliegenden Erfindung ist es, die Einrichtung zum Flüssigkeitskühlen von Zentraleinheiten derart auszugestalten, daß bei Ausfall eines der redundanten Kühlaggregate eine rasche Komplimentierung des ausgefallenen redundanten Kühlaggregats möglich ist.

Zur Lösung dieser Aufgabe wird gemäß der Erfindung die Einrichtung derart ausgebildet, daß zwei redundante Kühlaggregate vorgesehen sind, von denen jedes in einem eigenen Schrank 6, 7 untergebracht ist und die über eine Kühlmittelleitung 4 miteinander und eine weitere Kühlmittelleitung 5 mit der zugehörigen Zentraleinheit 8 verbunden sind, daß zwischen Kühlmittelzu- bzw. Abfluß des jeweiligen Kühlaggregates und der beiden verbindunden Kühlmittelleitung 4 eine Trennstelle 3 vorgesehen ist, vor und hinter der jeweils ein Kühlmittelabsperrhahn 1, 2 angeordnet ist.

Außerdem ist es vorteilhaft, daß unterhalb der Schränke 6, 6, 8 ein Doppelboden 9 vorgesehen ist, indem die Kühlmittelleitungen 4, 5 verlegt sind.

Durch diese Maßnahmen ist gewährleistet, daß das defekte Kühlaggregat in kurzer Zeit von der Kühlmittelleitung getrennt und durch ein intaktes Gerät ersetzt werden kann, sodaß die allenfalls anfallende Reperatur nicht sofort und an Ort und Stelle sondern ohne Zeitdruck an jedem beliebigen Ort z.B. am Fertigungsort durchgeführt werden kann.

Anhand des Ausführungsbeispiels nach der FIG wird die Erfindung näher erläutert. Im Schrank 8 ist die Zentraleinheit eines Datensystems untergebracht. Zur Kühlung werden zwei redundant geschaltete Kühlaggregate verwendet, die jedoch getrennt in zwei unterschiedlichen Schränken 6, 7 untergebracht sind. Beide Kühlaggregate sind über eine Kühlmittelleitung 4 miteinander verbunden und eine weitere Kühlmittelleitung 5 führt von dieser gemeinsamen Leitung 4 zur Zentraleinheit 8. Die beiden Kühlaggregate sind mit der gemeinsamen Kühlmittelleitung 4 über eine leicht lösbare Trennstelle 3 verbunden. Vor und nach jeder Trennstelle ist zudem ein Kühlmittelabsperrhahn 1, 2 vorgesehen. Ein weiterer Kühlmittelabsperrhahn liegt dann jeweils zwischen dieser Kühlmittelleitung 4 und der Kühlmittelleitung 5 ist ebenfalls eine Trennstelle vorgesehen, der jeweils ein Kühlmittelabsperrhahn 10 nachgeordnet ist.

Die Kühlmittelleitungen sind in einem Doppelboden 9, der sich unterhalb der Zentraleinheit und der Kühlaggregate befindet verlegt.

Bei Ausfall eines der Kühlaggregate wird automatisch auf das zweite Aggregat umgeschaltet. An dem ausgefallenen Kühlaggregat werden dann die Kühlmittelhähne 1 und 2 abgesperrt und die Verschraubung gelöst. Die Zentraleinheit arbeitet mit dem betriebsbereiten Kühlaggregat weiter. Das defekte Aggregat kann entfernt und durch ein funktionsfähiges ersetzt werden. Nach Anschluß und Öffnen der geschlossenen Hähne kann aufgrund einer Gleichverteilung der Betriebszeiten eine wechselseitige Umschaltung zwischen den beiden betriebsbereiten Kühlaggregaten wieder aufgenommen werden. Das defekte Kühlaggregat kann dann unabhängig vom Betrieb repariert werden.

Die Erfindung bezieht sich auf eine Einrichtung zum Flüssigkeitskühlen von Zentraleinheiten der Datentechnik, dabei werden redundante Kühlaggregate verwendet. Wird eines der redundanten Kühlaggregate defekt, soll das Kühlsystem möglichst rasch in seiner Redundanz wieder hergestellt werden. Die Erfindung sieht hierfür zwei redundante Kühlaggregate vor, von denen jedes in einem eigenen Schrank 6, 7 untergebracht ist und die über eine gemeinsame Kühlmittelleitung 4 miteinander und eine weitere Kühlmittelleitung 5 mit dazugehörigen Zentraleinheit 8 verbunden sind. Zwischen Kühlmittelzu- bzw. Abfluß des jeweiligen Kühlaggregates und der beide verbindenden Kühlmittelleitung 4 ist eine Trennstelle 3 vorgesehen, vor und hinter der jeweils ein Kühlmittelabsperrhahn 1, 2 angeordnet ist.


Bezugszeichenliste

1 = Kühlmittelabsperrhahn
2 = Kühlmittelabsperrhahn
3 = Trennstelle
4 = Kühlmittelleitung
5 = Kühlmittelleitung
6 = Schrank
7 = Schrank
8 = Zentraleinheit
9 = Doppelboden

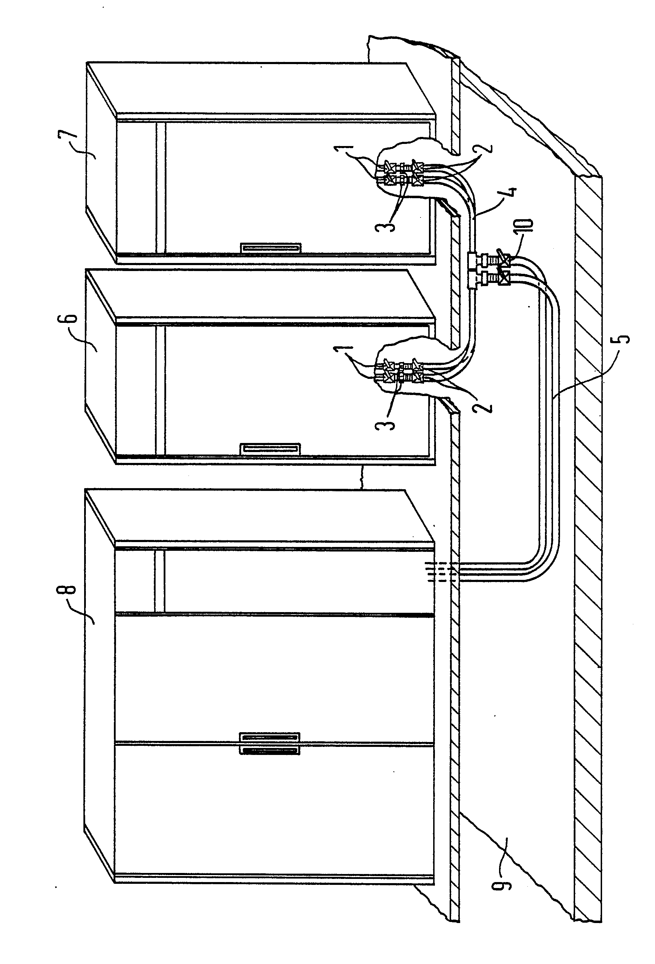

**Ansprüche**

1. Einrichtung zum Flüssigkeitskühlen von Zentraleinheiten der Datentechnik,
**dadurch gekennzeichnet,** daß zwei redundante Kühlaggregate vorgesehen sind, von denen jedes in einem eigenen Schrank (6, 7) untergebracht ist und die über eine Kühlmittelleitung (4) miteinander und eine weitere Kühlmittelleitung (5) mit der zugehörigen Zentraleinheit (8) verbunden sind, daß zwischen Kühlmittelzu-bzw. Abfluß des jeweiligen Kühlaggregates und der beiden verbindenden Kühlmittelleitung (4) eine Trennstelle (3) vorgesehen ist, vor und hinter der jeweils ein Kühlmittelabsperrhahn (1, 2) angeordnet ist.

2. Einrichtung zum Flüssigkeitskühlen von Zentraleinheiten der Datentechnik,
**dadurch gekennzeichnet,** daß unterhalb der Schränke (6, 7, 8) ein Doppelboden (9) vorgesehen ist, indem die Kühlmittelleitungen (4, 5) verlegt sind.

0 253 206